# EUROPEAN PATENT APPLICATION

(11) **EP 4 734 683 A1**
(43) Date of publication of application: **29.04.2026**
(21) Application number: 24858610.9
(22) Date of filing: 28.08.2024
(51) Int. Cl.: H05K 7/20

(54) **HEAT DISSIPATION METHOD AND ELECTRONIC DEVICE**

(30) Priority: 29.08.2023 CN 202311101059
(71) Applicant: Huawei Technologies Co., Ltd., Shenzhen, Guangdong 518129 (CN)
(72) Inventor: CHANG, Wenhao, Shenzhen, Guangdong 518129 (CN); WANG, Yukai, Shenzhen, Guangdong 518129 (CN); WANG, Sen, Shenzhen, Guangdong 518129 (CN); LAN, Wentao, Shenzhen, Guangdong 518129 (CN)
(74) Representative: Gill Jennings & Every LLP
(86) International application number: PCT/CN2024/115080
(87) International publication number: WO 2025/045076

(57) **Abstract**

This application provides a heat dissipation method and an electronic device. The heat dissipation method may include: when a second electronic device is attached to a first electronic device, obtaining a temperature of the first electronic device; and when the temperature of the first electronic device is greater than or equal to a first preset value, supplying power to the second electronic device, and controlling, at a first power, the second electronic device to drive a heat dissipation medium to move. In this technical solution, when the temperature is high, the first electronic device may control the second electronic device to drive the heat dissipation medium to move, to dissipate heat from the first electronic device, so that efficiency of dissipating heat from the first electronic device can be improved.

## Description

This application claims priority to Chinese Patent Application No. 202311101059.5, filed with the China National Intellectual Property Administration on August 29, 2023 and entitled "HEAT DISSIPATION METHOD AND ELECTRONIC DEVICE", which is incorporated herein by reference in its entirety.

### TECHNICAL FIELD

Embodiments of this application relate to the field of electronic technologies, and more specifically, to a heat dissipation method and an electronic device.

### BACKGROUND

Currently, when a user uses an electronic device, the electronic device generally generates heat. Especially in some scenarios with high power consumption, for example, in a scenario in which the user uses the electronic device to play a game or watch a video, the electronic device heats up severely. A high temperature of the electronic device affects performance of the electronic device.

To maintain good performance of the electronic device, heat is generally dissipated from the electronic device. For example, a vapor chamber or a graphite sheet can be used for heat dissipation. In this solution, heat dissipation relies on a back plate of the electronic device, and heat dissipation effect is poor.

Therefore, how to efficiently dissipate heat from the electronic device becomes a technical problem to be resolved.

### SUMMARY

This application provides a heat dissipation method and an electronic device, to efficiently dissipate heat from an electronic device.

According to a first aspect, a heat dissipation method is provided. The method is applied to a first electronic device. The method includes: when a second electronic device is attached to the first electronic device, obtaining a temperature of the first electronic device; and when the temperature of the first electronic device is greater than or equal to a first preset value, supplying power to the second electronic device, and controlling, at a first power, the second electronic device to drive a heat dissipation medium to move.

According to this embodiment of this application, when the second electronic device is attached to the first electronic device, the temperature of the first electronic device may be obtained, and when the temperature of the first electronic device is greater than or equal to the first preset value, power is supplied to the second electronic device, and the second electronic device is controlled to drive the heat dissipation medium to move.

In this way, when the temperature is high, the first electronic device can accurately control the second electronic device to drive the heat dissipation medium to move, to dissipate heat from the first electronic device. Because the second electronic device is attached to the first electronic device, when the heat dissipation medium in the second electronic device moves, heat on a back plate of the first electronic device can be quickly taken away. This can efficiently dissipate heat from the first electronic device.

With reference to the first aspect, in an implementation of the first aspect, controlling, at the first power, the second electronic device to drive the heat dissipation medium to move includes: sending first indication information to the second electronic device, where the first indication information indicates the second electronic device to drive, at the first power, the heat dissipation medium to move.

According to this embodiment of this application, the first electronic device may send the first indication information to the second electronic device, to indicate the second electronic device to drive, at the first power, the heat dissipation medium to move. In this way, the first electronic device can accurately control, by using the first indication information, a driving force used by the second electronic device to work, to accurately control heat dissipation for the first electronic device.

In another embodiment, the first electronic device may not send the first indication information to the second electronic device, but directly supply power to the second electronic device at the first power.

With reference to the first aspect, in an implementation of the first aspect, the method further includes: after first preset duration, controlling, at a second power, the second electronic device to drive the heat dissipation medium to move, where the second power is less than the first power.

A specific value of the first preset duration is not limited in this application. For example, the first preset duration may be 1 minute or 30 seconds.

According to this embodiment of this application, when the second electronic device starts to drive the heat dissipation medium to move, a larger driving force is required, and after the heat dissipation medium starts to flow, a smaller driving force is required to maintain the flow. Therefore, after the first preset duration, the first electronic device controls, at the second power, the second electronic device to work, to reduce power consumption of the first electronic device.

With reference to the first aspect, in an implementation of the first aspect, the method further includes: when the temperature of the first electronic device is greater than or equal to a second preset value and is less than the first preset value, sending second indication information to the second electronic device, where the second indication information indicates the second electronic device to drive, at a third power, the heat dissipation medium to move, and the third power is less than the first power.

According to this embodiment of this application, after the second electronic device starts to work to dissipate heat from the first electronic device, the temperature of the first electronic device correspondingly decreases. When the temperature of the first electronic device is greater than or equal to the second preset value and is less than the first preset value, the second indication information may be sent to the second electronic device, to indicate the second electronic device to drive, at the third power less than the first power, the heat dissipation medium to move. This can reduce power consumption of the first electronic device while dissipating heat.

With reference to the first aspect, in an implementation of the first aspect, the method further includes: When the temperature of the first electronic device is less than the second preset value, the first electronic device stops supplying power to the second electronic device.

According to this embodiment of this application, as the second electronic device works, the temperature of the first electronic device decreases, and when the temperature of the first electronic device is less than the second preset value, the first electronic device may stop supplying power to the second electronic device, to stop heat dissipation. This can avoid a case in which the second electronic device still works when the temperature of the first electronic device is already low.

With reference to the first aspect, in an implementation of the first aspect, the method further includes: When the first electronic device is in a first state, the first electronic device stops supplying power to the second electronic device.

For example, the first state may include but is not limited to a voice call state, a video call state, a recording state, or a low battery level state.

According to this embodiment of this application, because the second electronic device relies on power supply of the first electronic device to work, and the second electronic device generates vibration during working, when the first electronic device is in the first state, the first electronic device may stop supplying power to the second electronic device, to reduce impact on a current service of the first electronic device or reduce power consumption of the first electronic device.

With reference to the first aspect, in an implementation of the first aspect, before controlling, at the first power, the second electronic device to drive the heat dissipation medium to move, the method further includes: obtaining device information of the second electronic device; and determining, based on the device information, that the second electronic device is a heat dissipation device.

According to this embodiment of this application, the first electronic device may further obtain the device information of the second electronic device, and further determine, based on the device information, that the second electronic device is a heat dissipation device. This technical solution helps the first electronic device determine a device type of the second electronic device.

With reference to the first aspect, in an implementation of the first aspect, the method further includes: when the second electronic device is attached to the first electronic device for the first time, controlling the second electronic device to drive the heat dissipation medium to move for second preset duration; or when the second electronic device is attached to the first electronic device for the non-first time, the first electronic device stops supplying power to the second electronic device.

According to this embodiment of this application, when the second electronic device is attached to the first electronic device for the first time, the first electronic device may control the second electronic device to work for the second preset duration, to present, to a user, effect of dissipating heat from the first electronic device by the second electronic device. When the second electronic device is attached to the first electronic device for the non-first time, the first electronic device stops supplying power to the second electronic device, to reduce power consumption.

With reference to the first aspect, in an implementation of the first aspect, before supplying power to the second electronic device, the method further includes: determining, by using a Hall component, that the second electronic device is attached to the first electronic device.

According to this embodiment of this application, the first electronic device can conveniently determine, by using the Hall component, whether the second electronic device is attached.

With reference to the first aspect, in an implementation of the first aspect, the method further includes: The first electronic device supplies power to the second electronic device or stops supplying power to the second electronic device based on an operation of a user.

According to this embodiment of this application, the first electronic device may further supply power to the second electronic device or stop supplying power to the second electronic device based on the operation of the user. In this way, the user can autonomously determine whether to have the second electronic device dissipate heat from the first electronic device.

With reference to the first aspect, in an implementation of the first aspect, supplying power to the second electronic device includes: supplying power to the second electronic device in a wireless reverse charging manner.

According to this embodiment of this application, the first electronic device may have a wireless reverse charging function, to conveniently supply power to the attached second electronic device.

In another example, the first electronic device may alternatively supply power to the second electronic device in a wired manner. This is not limited in embodiments of this application.

According to a second aspect, a heat dissipation device is provided. The method is applied to a second electronic device. The method includes: receiving power supplied by a first electronic device; and driving, at a first power, a heat dissipation medium to move.

According to this embodiment of this application, the second electronic device drives, at the first power based on power supply of the first electronic device, the heat dissipation medium to move, to dissipate heat from the first electronic device based on power supply of the first electronic device.

With reference to the second aspect, in an implementation of the second aspect, driving, at the first power, the heat dissipation medium to move includes: receiving first indication information sent by the first electronic device; and driving, based on the first indication information at the first power, the heat dissipation medium to move.

According to this embodiment of this application, the second electronic device may receive the first indication information sent by the first electronic device, and drive, based on the first indication information at the first power, the heat dissipation medium to move. In this way, the first electronic device can accurately control a driving force used by the second electronic device to work.

With reference to the second aspect, in an implementation of the second aspect, the method further includes: after first preset duration, driving, at a second power, the heat dissipation medium to move, where the second power is less than the first power.

According to this embodiment of this application, after the heat dissipation medium starts to flow, a smaller driving force is required. In this case, the second electronic device may drive, at the second power, the heat dissipation medium to move, to reduce power consumption.

With reference to the second aspect, in an implementation of the second aspect, the method further includes: receiving second indication information sent by the first electronic device; and driving, based on the second indication information at a third power, the heat dissipation medium to move, where the third power is less than the first power.

According to this embodiment of this application, the second electronic device may further receive the second indication information sent by the first electronic device, and drive, based on the second indication information at the third power less than the first power, the heat dissipation medium to move. This technical solution can reduce power consumption of the first electronic device.

According to a third aspect, an electronic device is provided, including one or more processors and one or more memories. The one or more memories store one or more programs. When the one or more programs are executed by the one or more processors, the heat dissipation method according to the first aspect and any one of the possible implementations of the first aspect is performed.

According to a fourth aspect, an electronic device is provided, including one or more processors and one or more memories. The one or more memories store one or more programs. When the one or more programs are executed by the one or more processors, the heat dissipation method according to the second aspect and any one of the possible implementations of the second aspect is performed.

In another embodiment, this application further provides a system, including the electronic devices according to the third aspect and the fourth aspect.

According to a fifth aspect, a heat dissipation apparatus is provided, including a module configured to implement the heat dissipation method according to the first aspect and any one of the possible implementations of the first aspect.

According to a sixth aspect, a chip is provided. The chip includes a processor and a communication interface. The communication interface is configured to receive a signal and transmit the signal to the processor, and the processor processes the signal, so that the heat dissipation method according to the first aspect and any one of the possible implementations of the first aspect is performed.

According to a seventh aspect, a chip is provided. The chip includes a processor and a communication interface. The communication interface is configured to receive a signal and transmit the signal to the processor, and the processor processes the signal, so that the heat dissipation method according to the second aspect and any one of the possible implementations of the second aspect is performed.

According to an eighth aspect, a readable storage medium is provided. The readable storage medium stores instructions. When the instructions are run on an electronic device, the heat dissipation method according to the first aspect and any one of the possible implementations of the first aspect is performed.

According to a ninth aspect, a readable storage medium is provided. The readable storage medium stores instructions. When the instructions are run on an electronic device, the heat dissipation method according to the second aspect and any one of the possible implementations of the second aspect is performed.

According to a tenth aspect, a program product is provided. The program product includes program code. When the program code is run on an electronic device, the heat dissipation method according to the first aspect and any one of the possible implementations of the first aspect is performed.

According to an eleventh aspect, a program product is provided. The program product includes program code. When the program code is run on an electronic device, the heat dissipation method according to the second aspect and any one of the possible implementations of the second aspect is performed.

### BRIEF DESCRIPTION OF DRAWINGS

FIG. 1 is a diagram of a structure of an electronic device according to an embodiment of this application;
FIG. 2 is a diagram of a software structure of an electronic device according to an embodiment of this application;
FIG. 3 is a diagram of an architecture of a heat dissipation device according to an embodiment of this application;
FIG. 4 is a diagram of an architecture of an electronic device according to an embodiment of this application;
FIG. 5 is an interaction diagram of a heat dissipation method according to an embodiment of this application;
FIG. 6 is an interaction diagram of another heat dissipation method according to an embodiment of this application;
FIG. 7 is an interaction diagram of another heat dissipation method according to an embodiment of this application;
FIG. 8 is a schematic flowchart of a heat dissipation method according to an embodiment of this application; and
FIG. 9 is a block diagram of an electronic device according to an embodiment of this application.

### DESCRIPTION OF EMBODIMENTS

The following describes technical solutions in this application with reference to accompanying drawings.

A heat dissipation method in embodiments of this application may be applied to a device such as a smartphone, a tablet computer, a notebook computer, a personal computer (personal computer, PC), an ultra-mobile personal computer (ultra-mobile personal computer, UMPC), a netbook, a vehicle-mounted device, a head unit, a wearable device, a foldable device, or an internet of things (internet of things, IOT) device.

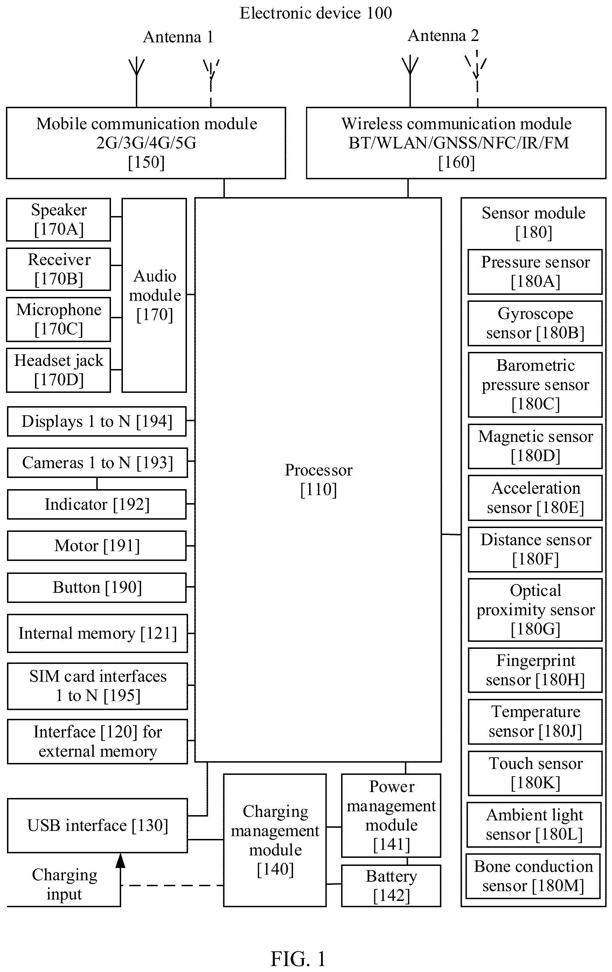

FIG. 1 is a diagram of a structure of an electronic device 100. The electronic device 100 may include a processor 110, an interface 120 for external memory, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a button 190, a motor 191, an indicator 192, a camera 193, a display 194, a subscriber identity module (subscriber identity module, SIM) card interface 195, and the like. The sensor module 180 may include a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

For example, the magnetic sensor 180D may be a Hall (hall) component, a magnetic sensor element with magnetoresistance effect, or the like. In this embodiment of this application, the electronic device 100 may determine, by using the magnetic sensor (for example, the Hall component), whether a heat dissipation device is attached to the electronic device 100.

It may be understood that the structure shown in this embodiment of this application does not constitute a specific limitation on the electronic device 100. In some other embodiments of this application, the electronic device 100 may include more or fewer components than those shown in the figure, or some components may be combined, or some components may be split, or different component arrangements may be used. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a memory, a video codec, a digital signal processor (digital signal processor, DSP), a baseband processor, a neural-network processing unit (neural-network processing unit, NPU), and/or the like. Different processing units may be independent components, or may be integrated into one or more processors.

The controller may be a nerve center and a command center of the electronic device 100. The controller may generate an operation control signal based on instruction operation code and a time sequence signal, to complete control of instruction reading and instruction execution.

A memory may be further disposed in the processor 110, and is configured to store instructions and data. In some embodiments, the memory in the processor 110 is a cache. The memory may store instructions or data just used or cyclically used by the processor 110. If the processor 110 needs to use the instructions or the data again, the processor may directly invoke the instructions or the data from the memory. This avoids repeated access, reduces waiting time of the processor 110, and improves system efficiency.

In some embodiments, the processor 110 may include one or more interfaces. The interfaces may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus interface, and/or the like.

The I2C interface is a two-way synchronization serial bus, and includes a serial data line (serial data line, SDA) and a serial clock line (serial clock line, SCL).

The I2S interface may be configured to perform audio communication. In some embodiments, the processor 110 may include a plurality of groups of I2S buses. The processor 110 may be coupled to the audio module 170 through the I2S bus, to implement communication between the processor 110 and the audio module 170.

The PCM interface may also be configured to: perform audio communication, and sample, quantize, and encode an analog signal. In some embodiments, the audio module 170 may be coupled to the wireless communication module 160 through a PCM bus interface.

The UART interface is a universal serial data bus, and is configured to perform asynchronous communication. The bus may be a two-way communication bus. The bus converts to-be-transmitted data between serial communication and parallel communication. In some embodiments, the UART interface is usually configured to connect the processor 110 to the wireless communication module 160.

The MIPI interface may be configured to connect the processor 110 to a peripheral component such as the display 194 or the camera 193.

The GPIO interface may be configured by using software. The GPIO interface may be configured as a control signal or a data signal. In some embodiments, the GPIO interface may be configured to connect the processor 110 to the camera 193, the display 194, the wireless communication module 160, the audio module 170, the sensor module 180, or the like.

The USB interface 130 is an interface that conforms to a USB standard specification, and may be specifically a mini USB interface, a micro USB interface, a USB Type-C interface, or the like. The USB interface 130 may be configured to connect to a charger to charge the electronic device 100, or may be configured to transmit data between the electronic device 100 and a peripheral device.

It may be understood that an interface connection relationship between modules illustrated in this embodiment of this application is merely an illustrative description, and does not constitute a limitation on the structure of the electronic device 100. In some other embodiments of this application, the electronic device 100 may alternatively use an interface connection manner different from that in the foregoing embodiment, or use a combination of a plurality of interface connection manners.

The charging management module 140 is configured to receive a charging input from a charger. The charger may be a wireless charger or a wired charger. In some embodiments of wired charging, the charging management module 140 may receive a charging input of a wired charger through the USB interface 130. In some embodiments of wireless charging, the charging management module 140 may receive a wireless charging input through a wireless charging coil of the electronic device 100. The charging management module 140 may further supply power to the device through the power management module 141 while charging the battery 142.

The power management module 141 is configured to connect to the battery 142, the charging management module 140, and the processor 110.

A wireless communication function of the electronic device 100 may be implemented through the antenna 1, the antenna 2, the mobile communication module 150, the wireless communication module 160, the modem processor, the baseband processor, and the like.

The mobile communication module 150 may provide a wireless communication solution that is applied to the electronic device 100 and that includes 2G/3G/4G/5G or the like.

The modem processor may include a modulator and a demodulator. The modulator is configured to modulate a to-be-sent low-frequency baseband signal into a medium-high frequency signal. The demodulator is configured to demodulate a received electromagnetic wave signal into a low-frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal through an audio device (which is not limited to the speaker 170A, the receiver 170B, and the like), and displays an image or a video through the display 194. In some embodiments, the modem processor may be an independent component. In some other embodiments, the modem processor may be independent of the processor 110, and is disposed in a same device as the mobile communication module 150 or another functional module.

The wireless communication module 160 may provide a wireless communication solution that is applied to the electronic device 100 and that includes a wireless local area network (wireless local area network, WLAN) (for example, a wireless fidelity (wireless fidelity, Wi-Fi) network), Bluetooth (Bluetooth, BT), Bluetooth low energy (Bluetooth low energy, BLE), a global navigation satellite system (global navigation satellite system, GNSS), frequency modulation (frequency modulation, FM), a near field communication (near field communication, NFC) technology, an infrared (infrared, IR) technology, or the like.

In some embodiments, in the electronic device 100, the antenna 1 is coupled to the mobile communication module 150, and the antenna 2 is coupled to the wireless communication module 160, so that the electronic device 100 can communicate with a network and another device by using a wireless communication technology.

The electronic device 100 implements a display function through the GPU, the display 194, the application processor, and the like. The GPU is a microprocessor for image processing, and is connected to the display 194 and the application processor. The GPU is configured to: perform mathematical and geometric computation, and render an image. The processor 110 may include one or more GPUs that execute program instructions to generate or change display information.

The display 194 is configured to display an image, a video, and the like. The display 194 includes a display panel. The display panel may be a liquid crystal display (liquid crystal display, LCD), or may be a display panel made of one of materials such as an organic light-emitting diode (organic light-emitting diode, OLED), an active-matrix organic light-emitting diode (active-matrix organic light-emitting diode, AMOLED), a flexible light-emitting diode (flexible light-emitting diode, FLED), a mini-LED, a micro-LED, a micro-OLED, or a quantum dot light-emitting diode (quantum dot light-emitting diode, QLED). In some embodiments, the electronic device 100 may include one or N displays 194, where N is a positive integer greater than 1.

In this embodiment of this application, the electronic device 100 may display, on the display 194, an image, and display an image on which digital watermark information is superimposed.

The electronic device 100 may implement a photographing function through the ISP, the camera 193, the video codec, the GPU, the display 194, the application processor, and the like.

The ISP is configured to process data fed back by the camera 193. The camera 193 is configured to capture a static image or a video. In this application, the camera 193 may be configured to obtain an image displayed on a display of another device.

The digital signal processor is configured to process a digital signal, and may process another digital signal in addition to a digital image signal.

The video codec is configured to compress or decompress a digital video. The electronic device 100 may support one or more video codecs.

The interface 120 for external memory may be configured to connect to an external storage card, for example, a micro SD card, to extend a storage capability of the electronic device 100.

The internal memory 121 may be configured to store computer-executable program code. The executable program code includes instructions. The processor 110 runs the instructions stored in the internal memory 121, to perform various function applications and data processing of the electronic device 100.

The electronic device 100 may implement an audio function, for example, music playing and recording, through the audio module 170, the speaker 170A, the receiver 170B, the microphone 170C, the headset jack 170D, the application processor, and the like.

The audio module 170 is configured to convert digital audio information into an analog audio signal for output, and is also configured to convert an analog audio input into a digital audio signal.

The speaker 170A, also referred to as a "loudspeaker", is configured to convert an audio electrical signal into a sound signal.

The receiver 170B, also referred to as an "earpiece", is configured to convert an audio electrical signal into a sound signal.

The microphone 170C, also referred to as a "mike" or a "mic", is configured to convert a sound signal into an electrical signal.

The headset jack 170D is configured to connect to a wired headset.

The pressure sensor 180A is configured to sense a pressure signal, and may convert the pressure signal into an electrical signal. In some embodiments, the pressure sensor 180A may be disposed on the display 194.

The gyroscope sensor 180B may be configured to determine a motion posture of the electronic device 100.

The barometric pressure sensor 180C is configured to measure barometric pressure. In some embodiments, the electronic device 100 calculates an altitude based on the barometric pressure measured by the barometric pressure sensor 180C, to assist in positioning and navigation.

The acceleration sensor 180E may detect magnitudes of accelerations of the electronic device 100 in various directions (usually on three axes).

The distance sensor 180F is configured to measure a distance.

The fingerprint sensor 180H is configured to collect a fingerprint.

The touch sensor 180K is also referred to as a "touch panel". The touch sensor 180K may be disposed on the display 194, and the touch sensor 180K and the display 194 form a touchscreen, which is also referred to as a "touch screen".

The bone conduction sensor 180M may obtain a vibration signal. In some embodiments, the bone conduction sensor 180M may obtain a vibration signal of a vibration bone of a human vocal-cord part. The bone conduction sensor 180M may also be in contact with a body pulse, to receive a blood pressure beating signal.

The button 190 includes a power button, a volume button, and the like.

The motor 191 may generate a vibration prompt.

The indicator 192 may be an indicator light, and may be configured to indicate a charging status and a battery level change, or may be configured to indicate a message, a missed call, a notification, and the like.

The SIM card interface 195 is configured to connect to a SIM card.

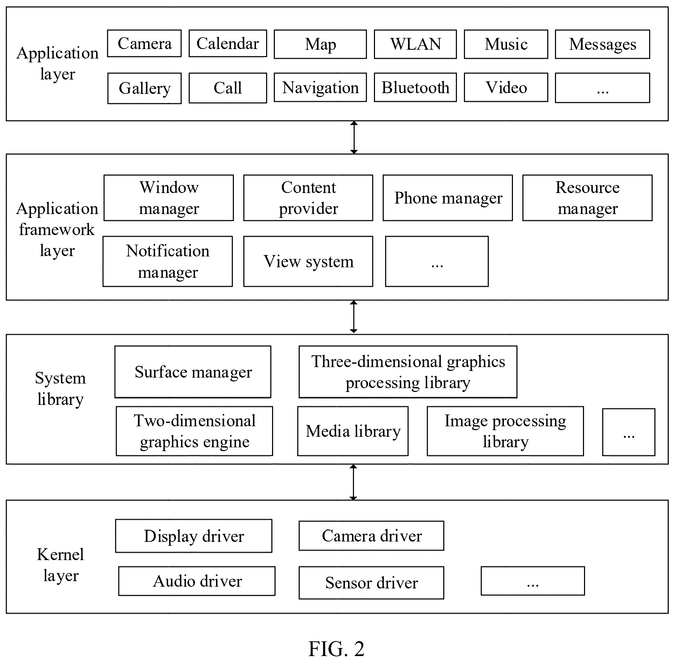

A software system of the electronic device 100 may use a layered architecture, an event-driven architecture, a microkernel architecture, a microservice architecture, or a cloud architecture. In embodiments of this application, an operating system with a layered architecture is used as an example to describe a software structure of the electronic device 100. FIG. 2 is a diagram of a software structure of a device according to an embodiment of this application.

Currently, when a user uses an electronic device, the electronic device generally generates heat. Especially in some scenarios with high power consumption, for example, in a scenario in which the user uses the electronic device to play a game or watch a video, the electronic device heats up severely. A high temperature of the electronic device affects performance of the electronic device.

To maintain good performance of the electronic device, heat is generally dissipated from the electronic device. For example, a vapor chamber or a graphite sheet can be used for heat dissipation. In this solution, natural heat dissipation relies on a back plate of the electronic device, and heat dissipation effect is poor.

In view of this, this application provides a heat dissipation method and an electronic device. In the technical solutions, when a heat dissipation device is already attached to an electronic device, when it is determined that a temperature of the electronic device is greater than a preset value, the heat dissipation device may be controlled to drive a heat dissipation medium to move, to efficiently dissipate heat from the electronic device.

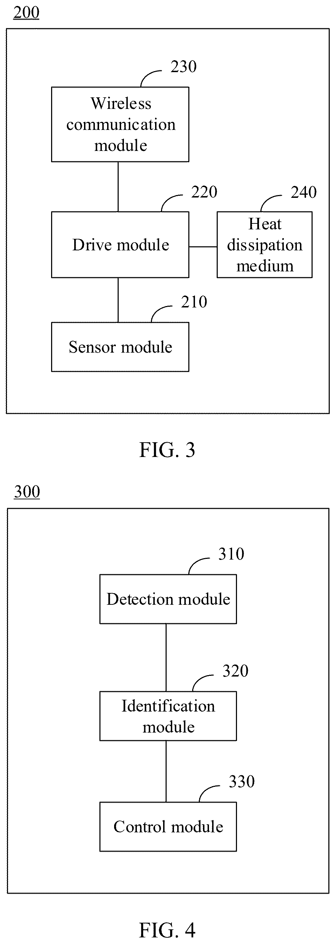

FIG. 3 is a diagram of an architecture of a heat dissipation device according to an embodiment of this application. As shown in FIG. 3, the heat dissipation device 200 may include at least a sensor module 210, a drive module 220, a wireless communication module 230, and a heat dissipation medium 240.

For example, the heat dissipation device 200 may be a heat dissipation cover, and may be configured to be attached to an electronic device such as a mobile phone or a tablet, and dissipate heat from the electronic device according to an instruction of the electronic device.

For example, the sensor module 210 may include a magnetic sensor, such as a Hall component. The sensor module 210 may be used by the electronic device to determine whether the heat dissipation device 200 is already attached to the electronic device.

In some implementations, the wireless communication module 230 may be configured to support wireless power supply to the heat dissipation device 200, and the drive module 220 may drive, based on power supply of the electronic device, the heat dissipation medium to move. For example, the wireless communication module 230 may include a receiving coil, and the electronic device to which the heat dissipation device 200 is attached has a wireless reverse charging function. When the electronic device wirelessly supplies power to the heat dissipation device, the electronic device may transmit a power supply through a transmitting coil, the receiving coil in the heat dissipation device senses a corresponding magnetic field and converts the magnetic field into an induced voltage, and a direct current power supply is obtained through rectification. The direct current power supply may act on the drive module 220, and the drive module 220 may drive the heat dissipation medium to move, to dissipate heat from the electronic device.

It should be understood that wireless reverse charging may also be referred to as wireless and reverse charging, reverse charging, or the like.

In some implementations, the electronic device may adjust a working power of the drive module 220 based on a power of wireless power supply to the heat dissipation device 200, to adjust a movement speed of the heat dissipation medium. Alternatively, when supplying power to the heat dissipation device 200, the electronic device may further send indication information to the heat dissipation device 200, to indicate the heat dissipation device to drive, by using different driving forces, the heat dissipation medium to move, so as to accurately control a temperature of the electronic device.

The drive module 220 may be a micropump, and the micropump may be used to enable the heat dissipation medium to move.

The heat dissipation medium 240 may be a liquid cooling medium. For example, the liquid cooling medium may include water, fluoride liquid, mineral oil, or the like. Specific content of the liquid cooling medium is not limited in embodiments of this application. The heat dissipation medium may alternatively be a liquid-gas mixture or the like.

In some embodiments, the heat dissipation medium 240 in the heat dissipation device 200 may alternatively be replaced with a fan, and the drive module 220 may control, when an instruction of the electronic device is received, the fan to move, to dissipate heat from the electronic device. Alternatively, the heat dissipation device 200 may include both the heat dissipation medium 240 and a fan. When an instruction of the electronic device is received, the drive module 220 may drive the heat dissipation medium to move and control the fan to move, to quickly dissipate heat from the electronic device.

FIG. 4 is a diagram of an architecture of an electronic device according to an embodiment of this application. As shown in FIG. 4, the electronic device 300 may include at least a detection module 310, an identification module 320, and a control module 330.

The detection module 310 may be configured to detect whether the heat dissipation device 200 is in an attached state. For example, the detection module 310 may be configured to: receive data of the sensor module 210 (for example, the Hall component) of the heat dissipation device 200, and determine, based on the data, whether the heat dissipation device is in the attached state.

In some implementations, when the heat dissipation device 200 is not attached to the electronic device 300, the heat dissipation device 200 is attached to the electronic device 300. For example, the electronic device 300 includes a Hall component 1, and the sensor module 210 is a Hall component 2. A Hall component generally includes two output pins, which are configured to output a north (north, N) pole proximity signal and a south (south, S) pole proximity signal respectively. When neither of the two output pins outputs a signal, an output level is a high level by default. When the two output pins output one signal, an output level is a low level. The detection module 310 may determine, by sensing a change in an output level of two output pins of the Hall component 1 in the electronic device 300, whether the heat dissipation device 200 is attached. For example, when the heat dissipation device 200 is not attached to the electronic device 300, the Hall component 1 does not sense a change in an external magnetic field, and in this case, the output level of the two output pins of the Hall component 1 is a high level. The output pins of the Hall component 1 are connected to a general-purpose input/output (general-purpose input/output, GPIO) pin of the detection module 310, so that the detection module 310 may obtain a high level signal, to determine that the heat dissipation device 200 is not attached to the electronic device 300. When the heat dissipation device 200 is attached to the electronic device 300, the Hall component 1 senses a magnetic field of the Hall component 2, and in this case, the output pin of the Hall component 1 may output an N-pole proximity signal or an S-pole proximity signal, and the output level is a low level. The detection module 310 may obtain a low level signal, to determine that the heat dissipation device 200 is attached to the electronic device 300.

In some implementations, when the heat dissipation device 200 is already attached to the electronic device 300 and the electronic device 300 is in a power-off state, when the electronic device 300 changes from the power-off state to a power-on state, the detection module 310 of the electronic device 300 may also determine, based on a low level signal output by the output pins of the Hall component 1, that the heat dissipation device 200 is in the attached state.

In this embodiment of this application, when the detection module 310 detects that the heat dissipation device 200 is in the attached state, the electronic device 300 may supply power to the heat dissipation device 200. For example, the electronic device 300 may have a wireless reverse charging function, so that power supply to the heat dissipation device 200 can be implemented by using the wireless reverse charging function.

The identification module 320 may be configured to obtain device information of the heat dissipation device 200 by using a wireless charging protocol (for example, a Qi protocol). The device information may include a product serial number, a product type, configuration information, and the like of the heat dissipation device. Therefore, the identification module 320 may determine, based on the device information of the heat dissipation device 200, whether the heat dissipation device 200 is a heat dissipation device.

After the identification module 320 identifies that the heat dissipation device 200 is a heat dissipation device, the control module 330 may determine, based on a temperature of the electronic device 300, whether to send an instruction to the heat dissipation device 200 to instruct the heat dissipation device 200 to work, to dissipate heat from the electronic device 300.

In some implementations, when the temperature of the electronic device is greater than a preset value, the control module 330 may control the electronic device 300 to send indication information to the heat dissipation device 200 by using the wireless charging protocol, to indicate the heat dissipation device 200 to work. The heat dissipation device 200 may drive, based on the indication information, the heat dissipation medium to move, to dissipate heat from the electronic device 300.

In some implementations, when the temperature of the electronic device is greater than the preset value, the control module 330 may control the electronic device 300 to supply power to the heat dissipation device 200 by using the wireless charging protocol, so that the heat dissipation device 200 can drive the heat dissipation medium to move, to dissipate heat from the electronic device 300.

In another example, the detection module 310, the identification module 320, and the control module 330 may be functional modules in the foregoing processor 110.

In this embodiment of this application, the electronic device may determine whether the heat dissipation device is in the attached state, and when determining that the heat dissipation device is in the attached state, and determining that the temperature of the electronic device is greater than the preset value, control the heat dissipation device to work, to drive the heat dissipation medium to move. In this way, the heat dissipation device dissipates heat from the electronic device. In this technical solution, the temperature of the electronic device may be detected in real time, and when the temperature is high, the heat dissipation device is controlled in real time to work, to dissipate heat from the electronic device, so that effect of dissipating heat from the electronic device is better.

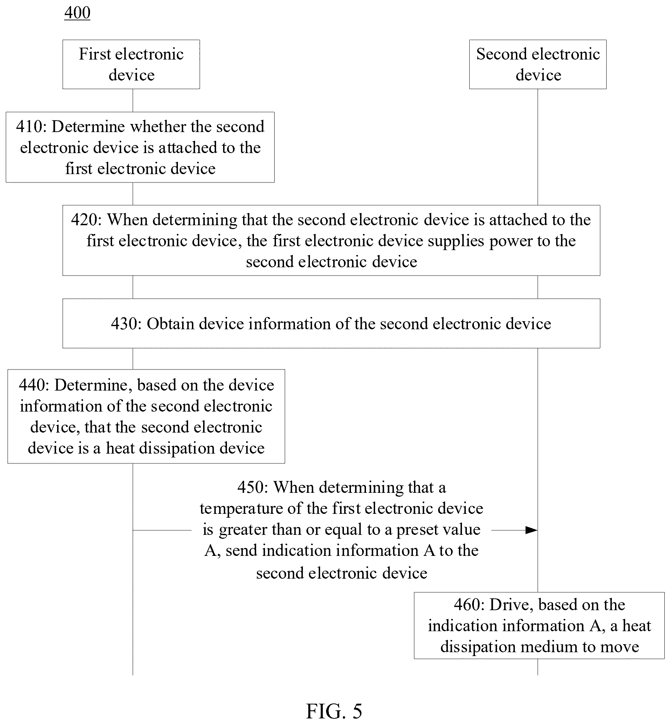

The following describes in detail the heat dissipation method in this application with reference to FIG. 5 to FIG. 8.

In embodiments of this application, a first electronic device may be a device that needs heat dissipation, such as a mobile phone or a tablet, and a second electronic device may be a heat dissipation device, such as a heat dissipation phone cover.

For example, FIG. 5 is an interaction diagram of a heat dissipation method according to an embodiment of this application. As shown in FIG. 5, the method 400 may include step 410 to step 460.

410: A first electronic device determines whether a second electronic device is attached to the first electronic device.

For example, both the first electronic device and the second electronic device may include a Hall component. The first electronic device may determine, by using the Hall component, whether the second electronic device is attached to the first electronic device. For details, refer to the foregoing related descriptions. For brevity, details are not described herein again.

420: When determining that the second electronic device is attached to the first electronic device, the first electronic device supplies power to the second electronic device.

In some implementations, the first electronic device has a wireless reverse charging function, so that the first electronic device can supply power to the second electronic device by using the wireless reverse charging function.

In some implementations, the first electronic device may alternatively enable the wireless reverse charging function based on an operation of a user, to supply power to the second electronic device. For example, a display interface for battery management of the first electronic device may include a function enabling/disabling button for the wireless reverse charging function, and the user may control, by tapping the function enabling/disabling button, the first electronic device to enable or disable the wireless reverse charging function.

In some implementations, the first electronic device may alternatively supply power to the second electronic device in another manner. This is not limited in embodiments of this application. For example, the first electronic device may alternatively supply power to the second electronic device in a wired manner.

430: The first electronic device obtains device information of the second electronic device.

In some implementations, when the first electronic device supplies power to the second electronic device by using the wireless reverse charging function, the first electronic device may obtain the device information of the second electronic device by using a wireless charging protocol. The device information may include one or more of information such as a product serial number, a product type, configuration information, and a media access control (media access control, MAC) address of the second electronic device.

For example, the first electronic device may send a request message to the second electronic device, and after receiving the request message, the second electronic device sends the device information of the second electronic device to the first electronic device, so that the first electronic device can obtain the device information of the second electronic device.

For another example, after the first electronic device wirelessly supplies power to the second electronic device, the second electronic device may actively send the device information of the second electronic device to the first electronic device.

440: The first electronic device determines, based on the device information of the second electronic device, that the second electronic device is a heat dissipation device.

After obtaining the device information of the second electronic device, the first electronic device may further determine, based on the device information of the second electronic device, that the second electronic device is a heat dissipation device.

450: When determining that a temperature of the first electronic device is greater than or equal to a preset value A, the first electronic device sends indication information A to the second electronic device, where the indication information A indicates the second electronic device to drive a heat dissipation medium to move. Correspondingly, the second electronic device receives the indication information A.

The first electronic device may detect the temperature of the first electronic device in real time, and when determining that the temperature of the first electronic device is greater than or equal to the preset value A, send the indication information A to the second electronic device, to indicate the second electronic device to drive the heat dissipation medium to move. Alternatively, the indication information A may be understood as indicating the second electronic device to work.

A specific value of the preset value A is not limited in embodiments of this application. For example, the preset value A may be 40 degrees or 50 degrees.

In another implementation, after the first electronic device determines that the second electronic device is a heat dissipation device, if the temperature of the first electronic device is less than the preset value A, the first electronic device may stop supplying power to the second electronic device, to reduce power consumption of the first electronic device. Then, when determining that the temperature of the first electronic device is greater than the preset value A, the first electronic device may supply power to the second electronic device again, so that the second electronic device works.

460: The second electronic device drives, based on the indication information A, the heat dissipation medium to move.

After receiving the indication information A, the second electronic device may drive, based on the indication information A, the heat dissipation medium to move. Because the second electronic device is attached to the first electronic device, the second electronic device can take away heat from a back plate of the first electronic device by driving the heat dissipation medium to move, to accelerate a speed of dissipating heat from the back plate of the first electronic device, and improve effect of dissipating heat from the first electronic device.

In another example, when the second electronic device starts to drive the heat dissipation medium to move, a larger driving force is required, and after the heat dissipation medium starts to flow, a smaller driving force is required. Therefore, to reduce power consumption of the first electronic device, the first electronic device may reduce a power of power supply to the second electronic device after supplying power to the second electronic device for preset duration T1. For example, after supplying power to the second electronic device for the preset duration T1, the first electronic device may reduce a duty cycle of wireless power supply to the second electronic device, to reduce the power of power supply to the second electronic device. For example, at fixed power supply frequency, the first electronic device may reduce power supply duration in each cycle, to reduce the duty cycle of wireless power supply to the second electronic device, so as to reduce the power of power supply to the second electronic device. In this way, the first electronic device can reduce power consumption of the first electronic device while driving the second electronic device to work.

A specific value of the preset duration T1 is not limited in this application. For example, the preset duration T1 may be 5 seconds or 8 seconds.

It should be understood that a specific sequence of performing step 410 to step 460 is not limited in embodiments of this application. In another example, some of step 410 to step 460 may not be performed or may be replaced with other steps. For example, when determining that the temperature is greater than or equal to the preset value A, the first electronic device may further determine whether the second electronic device is attached, and when determining that the second electronic device is attached, the first electronic device may supply power to the second electronic device, and control the second electronic device to drive the heat dissipation medium to move, to dissipate heat from the first electronic device.

In this embodiment of this application, the first electronic device may determine whether the second electronic device is in an attached state, and when determining that the second electronic device is in the attached state, and determining that the temperature of the first electronic device is greater than the preset value A, send the indication information to the second electronic device, to indicate the second electronic device to drive the heat dissipation medium to move. In this way, the second electronic device dissipates heat from the first electronic device.

In addition, in this technical solution, the temperature of the first electronic device may be detected in real time, and when the temperature is high, the second electronic device is controlled in real time to work, to dissipate heat from the first electronic device, so that effect of dissipating heat from the first electronic device is better.

In another example, after step 440, the method 400 may further include the following step.

445: The first electronic device determines whether the second electronic device is attached for the first time.

In some implementations, when determining that the second electronic device is attached for the first time, the first electronic device may send indication information A1 to the second electronic device, where the indication information A1 may indicate the second electronic device to work for preset duration T2. In this way, the first electronic device may present, to the user, effect of controlling the second electronic device to perform heat dissipation.

Then, the first electronic device may mark the second electronic device, so that the first electronic device can determine, when the second electronic device is attached next time, that the second electronic device is attached for the non-first time, without presenting, to the user, effect of controlling the second electronic device to perform heat dissipation by the first electronic device.

Specific duration of the preset duration T2 is not limited in embodiments of this application. For example, the preset duration T2 may be 2.5 minutes or 1 minute.

In some implementations, when the first electronic device determines, based on mark information, that the second electronic device is attached for the non-first time, if in this case, the temperature of the first electronic device is less than the preset value A, the first electronic device may stop supplying power to the second electronic device. Alternatively, if in this case, the temperature of the first electronic device is less than the preset value A, although the first electronic device supplies power to the second electronic device, the first electronic device does not send indication information for working to the second electronic device.

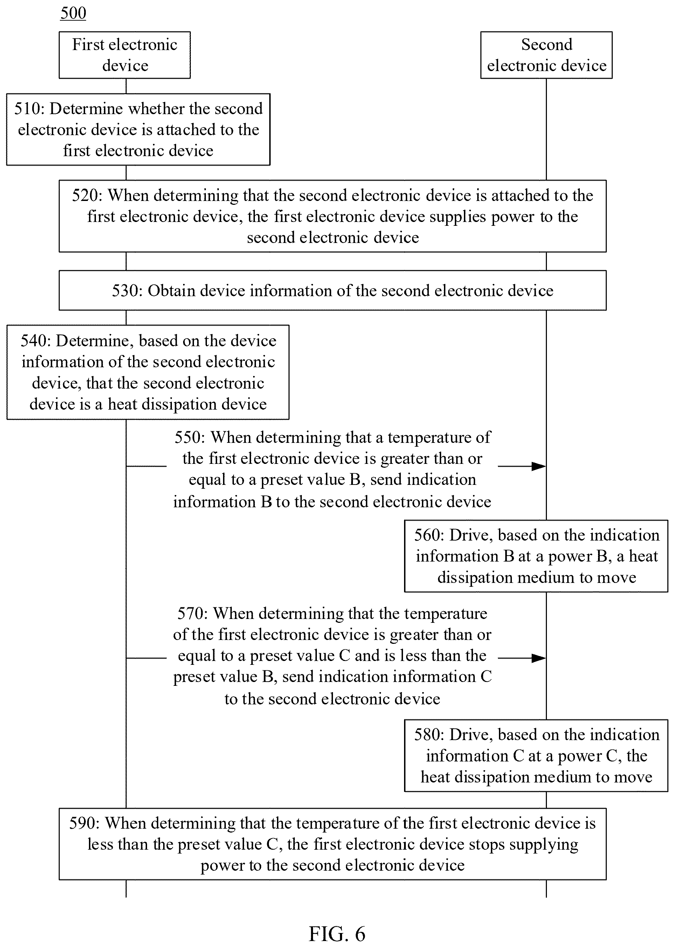

FIG. 6 is an interaction diagram of another heat dissipation method according to an embodiment of this application. As shown in FIG. 6, the method 500 may include step 510 to step 590.

510: A first electronic device determines whether a second electronic device is attached to the first electronic device.

520: When determining that the second electronic device is attached to the first electronic device, the first electronic device supplies power to the second electronic device.

530: The first electronic device obtains device information of the second electronic device.

540: The first electronic device determines, based on the device information of the second electronic device, that the second electronic device is a heat dissipation device.

It should be understood that, for step 510 to step 540, refer to the foregoing related descriptions of step 410 to step 440. For brevity, details are not described herein again.

550: When determining that a temperature of the first electronic device is greater than or equal to a preset value B, the first electronic device sends indication information B to the second electronic device, where the indication information B indicates the second electronic device to drive, at a power B, a heat dissipation medium to move. Correspondingly, the second electronic device receives the indication information B.

In some implementations, the first electronic device may detect the temperature in real time, and when determining that the temperature of the first electronic device is greater than or equal to the preset value B, send the indication information B to the second electronic device, where the indication information B may indicate the second electronic device to drive, at the power B, the heat dissipation medium to move.

In another implementation, after the first electronic device determines that the second electronic device is a heat dissipation device, if the temperature of the first electronic device is less than the preset value B, the first electronic device may stop supplying power to the second electronic device, to reduce power consumption of the first electronic device. Then, when determining that the temperature of the first electronic device is greater than or equal to the preset value B, the first electronic device may supply power to the second electronic device again, so that the second electronic device can work at the power B.

560: The second electronic device drives, based on the indication information B at the power B, the heat dissipation medium to move.

For example, the second electronic device may drive, at the power B, the heat dissipation medium to move at a speed of V1.

570: When determining that the temperature of the first electronic device is greater than or equal to a preset value C and is less than the preset value B, the first electronic device sends indication information C to the second electronic device, where the indication information C indicates the second electronic device to drive, at a power C, the heat dissipation medium to move. Correspondingly, the second electronic device receives the indication information C.

It should be understood that, as the second electronic device works, the heat dissipation medium continuously moves, to dissipate heat from the first electronic device. After the second electronic device works for a period of time, the temperature of the first electronic device decreases. When it is determined that the temperature of the first electronic device is greater than or equal to the preset value C and is less than the preset value B, the indication information C may be sent to the second electronic device, to indicate the second electronic device to drive, at the power C, the heat dissipation medium to move, where the power C may be less than the power B. This can reduce power consumption of the first electronic device.

In this embodiment of this application, the preset value B is greater than the preset value C. For example, the preset value B is 50 degrees, and the preset value C is 40 degrees; or the preset value B is 40 degrees, and the preset value C is 30 degrees. Specific values of the preset value B and the preset value C are not limited in embodiments of this application.

In another example, when determining that the temperature of the first electronic device is greater than or equal to the preset value C and is less than the preset value B, the first electronic device may reduce a power of power supply to the second electronic device from the power B to the power C, to reduce power consumption of the first electronic device.

580: The second electronic device drives, based on the indication information C at the power C, the heat dissipation medium to move.

For example, the second electronic device may drive, at the power C, the heat dissipation medium to move at a speed of V2, where V2 is less than V1.

590: When determining that the temperature of the first electronic device is less than the preset value C, the first electronic device stops supplying power to the second electronic device.

It should be understood that, as the second electronic device works, the temperature of the first electronic device continuously decreases, and when determining that the temperature of the first electronic device is less than the preset value C, the first electronic device may stop supplying power to the second electronic device. Because the temperature of the first electronic device is already reduced in this case, the second electronic device may be controlled to stop working, to reduce power consumption of the first electronic device.

In this embodiment of this application, the first electronic device may determine whether the second electronic device is in an attached state, and when determining that the second electronic device is in the attached state, and determining that the temperature of the first electronic device is high, send indication information to the second electronic device, to indicate the second electronic device to drive, at a higher power, the heat dissipation medium to move, so as to quickly dissipate heat from the first electronic device. When the temperature of the first electronic device decreases slightly, the first electronic device may control the second electronic device to drive, at a lower power, the heat dissipation medium to move, to reduce power consumption of the first electronic device while dissipating heat from the first electronic device. When determining that the temperature of the first electronic device decreases to a value below a preset value, the first electronic device may stop supplying power to the second electronic device, so that the second electronic device stops working.

In this way, in the technical solution, a working power of the second electronic device may be controlled in real time based on the temperature of the first electronic device, so that the temperature of the first electronic device can be regulated in real time.

In another example, after step 540, the method 500 may further include the following step.

545: The first electronic device determines whether the second electronic device is attached for the first time.

For step 545, refer to the foregoing related descriptions of step 445.

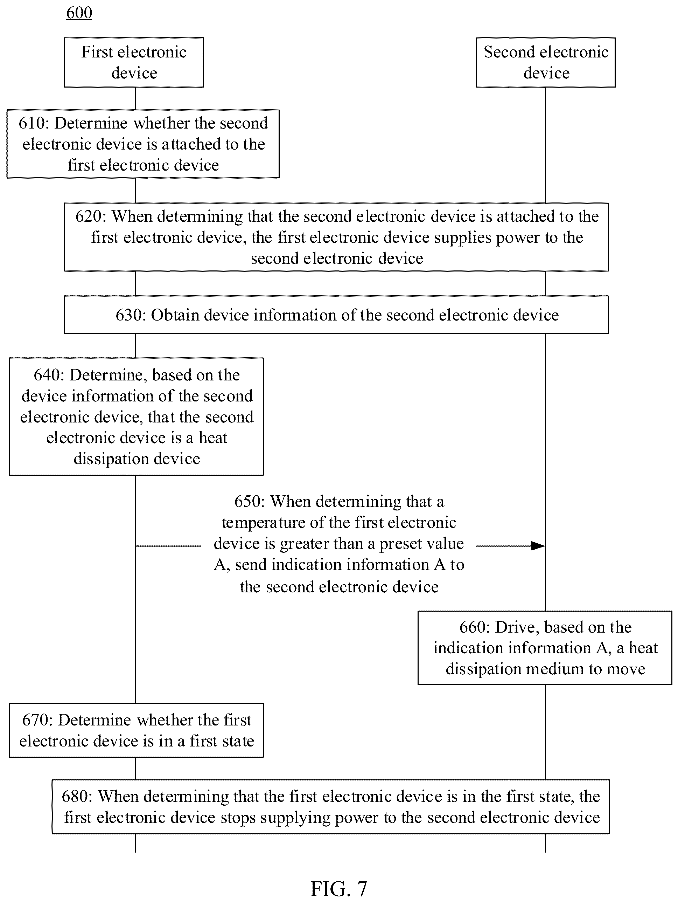

In some cases, in a process in which the first electronic device supplies power to the second electronic device, if it is determined that the first electronic device is in some specific states, such as a call state and a recording state, the first electronic device may stop supplying power to the second electronic device, so that the current state of the first electronic device is not affected; or when a battery level of the first electronic device is low, the first electronic device may also stop supplying power to the second electronic device, to reduce power consumption. This technical solution is described below with reference to FIG. 7.

FIG. 7 is an interaction diagram of another heat dissipation method according to an embodiment of this application. As shown in FIG. 7, the method 600 may include step 610 to step 680.

610: A first electronic device determines whether a second electronic device is attached to the first electronic device.

620: When determining that the second electronic device is attached to the first electronic device, the first electronic device supplies power to the second electronic device.

630: The first electronic device obtains device information of the second electronic device.

640: The first electronic device determines, based on the device information of the second electronic device, that the second electronic device is a heat dissipation device.

650: When determining that a temperature of the first electronic device is greater than a preset value A, the first electronic device sends indication information A to the second electronic device.

660: The second electronic device drives, based on the indication information A, a heat dissipation medium to move.

It should be understood that, for step 610 to step 660, refer to the foregoing related descriptions of step 410 to step 460. For brevity, details are not described herein again.

670: The first electronic device determines whether the first electronic device is in a first state.

For example, the first state may include but is not limited to a voice call state, a video call state, a recording state, or a battery level lower than a preset battery level value.

680: When determining that the first electronic device is in the first state, the first electronic device stops supplying power to the second electronic device.

When the first electronic device supplies power to the second electronic device, the second electronic device needs to drive the heat dissipation medium to move, and some components of the second electronic device vibrate slightly in a working process of the second electronic device. When the first electronic device is in the voice call state, the video call state, or the recording state, the vibration of the some components of the second electronic device affects call quality or recording quality for a user. Therefore, the first electronic device may stop supplying power to the second electronic device, to reduce interference to a service of the first electronic device.

Similarly, when the battery level of the first electronic device is lower than the preset battery level value, if power supply to the second electronic device continues, battery level consumption of the first electronic device is accelerated, causing the first electronic device to be on the verge of power off. Therefore, the first electronic device may stop supplying power to the second electronic device, to reduce battery level consumption of the first electronic device.

A specific value of the preset battery level value is not limited in embodiments of this application. For example, the preset battery level value is 20% or 25%.

A specific sequence of performing step 610 to step 680 is not limited in embodiments of this application. Some of step 610 to step 680 may not be performed or may be replaced with other steps. In another implementation, step 670 and step 680 may be performed after step 650. In this case, although the temperature of the first electronic device is high, because it is determined that the first electronic device is in the first state, the first electronic device may not supply power to the second electronic device. In this case, step 660 of the method 600 may not be performed.

In this embodiment of this application, in a process in which the first electronic device supplies power to the second electronic device, or when the first electronic device has a temperature greater than a preset value and is about to send indication information to the second electronic device, it may be determined whether the first electronic device is in a state of a call, recording, a low battery level, or the like. If it is determined that the first electronic device is in the foregoing state, the first electronic device may stop supplying power to the second electronic device, to ensure smooth operation of a current service of the first electronic device or reduce battery level consumption of the first electronic device.

It may be understood that the foregoing embodiments may be combined with each other or partially combined, to form a new technical solution. It shall not be considered that the technical solution goes beyond the protection scope of this application.

For example, in the method 500, in step 550 and step 570, the first electronic device may further determine whether the first electronic device is in a first state. If the first electronic device is not in the first state, the first electronic device may send indication information to the second electronic device, to indicate the second electronic device to work. If the first electronic device is in the first state, the first electronic device may stop supplying power to the second electronic device.

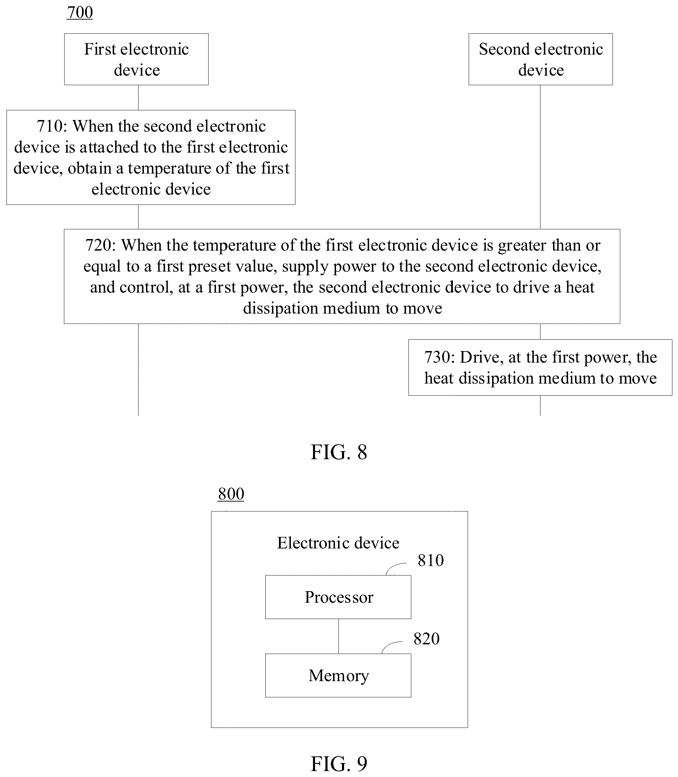

FIG. 8 is a schematic flowchart of a heat dissipation method according to an embodiment of this application. As shown in FIG. 8, the method 700 may be applied to an electronic device, and the method 700 may include step 710 to step 730.

710: When a second electronic device is attached to a first electronic device, obtain a temperature of the first electronic device.

For example, when the second electronic device is attached to the first electronic device, the first electronic device may obtain the temperature of the first electronic device by using a temperature sensor or the like.

In some implementations, the first electronic device may further determine, by using a Hall component, whether the second electronic device is attached. For details, refer to the foregoing related descriptions.

It should be understood that the first electronic device may further determine, in another manner, whether the second electronic device is attached. For example, the first electronic device may directly enable a reverse charging function. Then, if information about another device can be obtained, it may be determined that the second electronic device is attached. Otherwise, it may be determined that the second electronic device is not attached.

720: When the temperature of the first electronic device is greater than or equal to a preset value, supply power to the second electronic device, and control, at a first power, the second electronic device to drive a heat dissipation medium to move.

When the second electronic device is attached to the first electronic device, the first electronic device may detect the temperature of the first electronic device in real time. When the temperature of the first electronic device is greater than or equal to a first preset value, the first electronic device supplies power to the second electronic device, and controls, at the first power, the second electronic device to drive the heat dissipation medium to move.

A specific value of the first preset value is not limited in embodiments of this application. For example, the first preset value may be 40 degrees or 50 degrees.

A manner in which the first electronic device supplies power to the second electronic device may be wireless reverse charging, or may be a wired manner. This is not limited in embodiments of this application.

730: The second electronic device drives, at the first power, the heat dissipation medium to move.

The second electronic device may drive, at the first power based on power supply of the first electronic device, the heat dissipation medium to move, to dissipate heat from the first electronic device through movement of the heat dissipation medium.

The heat dissipation medium may be a liquid cooling medium. For example, the liquid cooling medium may include water, fluoride liquid, mineral oil, or the like. Specific content of the liquid cooling medium is not limited in embodiments of this application. The heat dissipation medium may alternatively be a liquid-gas mixture or the like.

In this embodiment of this application, when the second electronic device is attached to the first electronic device, the temperature of the first electronic device may be obtained, and when the temperature of the first electronic device is greater than or equal to the first preset value, power is supplied to the second electronic device, and the second electronic device is controlled to drive the heat dissipation medium to move. In this way, when the temperature is high, the first electronic device can accurately control the second electronic device to drive the heat dissipation medium to move, to dissipate heat from the first electronic device. Because the second electronic device is attached to the first electronic device, when the heat dissipation medium in the second electronic device moves, heat on a back plate of the first electronic device can be quickly taken away. This can efficiently dissipate heat from the first electronic device.

In another example, the second electronic device may further include a fan, and the second electronic device may further drive, based on power supply of the first electronic device, the fan to rotate, to accelerate energy flow on the back plate of the first electronic device, so as to dissipate heat from the first electronic device. Alternatively, based on power supply of the first electronic device, the second electronic device may drive the fan to rotate and drive the heat dissipation medium to move, to quickly dissipate heat from the first electronic device.

In some embodiments, that the first electronic device controls, at the first power, the second electronic device to drive the heat dissipation medium to move includes:

The first electronic device sends first indication information to the second electronic device, where the first indication information indicates the second electronic device to drive, at the first power, the heat dissipation medium to move.

For example, the first electronic device and the second electronic device may negotiate an initial power at which the second electronic device starts to drive the heat dissipation medium to move. For example, there may be a plurality of initial powers, which respectively correspond to a plurality of levels at which the second electronic device works. For example, 5 watts (watts, W) corresponds to a level 1, 10 W corresponds to a level 2, and 15 W corresponds to a level 3. In this case, the first indication information may indicate specific wattage, or may be identification information indicating corresponding wattage or a corresponding level.

According to this embodiment of this application, the first electronic device may send the first indication information to the second electronic device, to indicate the second electronic device to drive, at the first power, the heat dissipation medium to move. In this way, the first electronic device can accurately control, by using the first indication information, a driving force used by the second electronic device to work, to accurately control heat dissipation for the first electronic device.

In another embodiment, the first electronic device may not send the first indication information to the second electronic device, but directly supply power to the second electronic device at the first power.

In some embodiments, the method 700 further includes:
After first preset duration, the first electronic device controls, at a second power, the second electronic device to drive the heat dissipation medium to move, where the second power is less than the first power.

For example, the first power may be 10 W, and the second power may be 6 W.

A specific value of the first preset duration is not limited in this application. For example, the first preset duration may be 1 minute or 30 seconds.

In this embodiment of this application, when the second electronic device starts to drive the heat dissipation medium to move, a larger driving force is required, and after the heat dissipation medium starts to flow, a smaller driving force is required to maintain the flow. Therefore, after the first preset duration, the first electronic device controls, at the second power, the second electronic device to work, to reduce power consumption of the first electronic device.

In some embodiments, the method 700 further includes:
When the temperature of the first electronic device is greater than or equal to a second preset value and is less than the first preset value, the first electronic device sends second indication information to the second electronic device, where the second indication information indicates the second electronic device to drive, at a third power, the heat dissipation medium to move, and the third power is less than the first power.

Specific values of the first preset value and the second preset value are not limited in embodiments of this application. For example, the first preset value may be 50 degrees, and the second preset value may be 40 degrees; or the first preset value may be 45 degrees, and the second preset value may be 35 degrees.

Specific values of the first power and the third power are not limited in embodiments of this application. For example, the first power may be 15 W, and the third power may be 10 W.

In some implementations, the second indication information may indicate specific wattage, or may be identification information indicating corresponding wattage or a corresponding level.

In this embodiment of this application, after the second electronic device starts to work to dissipate heat from the first electronic device, the temperature of the first electronic device correspondingly decreases. When the temperature of the first electronic device is greater than or equal to the second preset value and is less than the first preset value, the second indication information may be sent to the second electronic device, to indicate the second electronic device to drive, at the third power less than the first power, the heat dissipation medium to move. This can reduce power consumption of the first electronic device while dissipating heat.

In another example, when the second electronic device is attached to the first electronic device, and when the temperature of the first electronic device is greater than or equal to the second preset value and is less than the first preset value, the first electronic device may directly send the second indication information to the second electronic device. In this way, when the temperature of the first electronic device varies, the first electronic device may send different indication information to the second electronic device, to indicate the second electronic device to drive, at different powers, the heat dissipation medium to move, so as to accurately dissipate heat from the first electronic device.

In some embodiments, the method 700 further includes:
When the temperature of the first electronic device is less than the second preset value, the first electronic device stops supplying power to the second electronic device.

For example, when the first electronic device supplies power to the second electronic device in a wireless reverse charging manner, and when the temperature of the first electronic device is less than the second preset value, the first electronic device may disable a wireless reverse charging function to stop supplying power to the second electronic device.

According to this embodiment of this application, as the second electronic device works, the temperature of the first electronic device decreases, and when the temperature of the first electronic device is less than the second preset value, the first electronic device may stop supplying power to the second electronic device, to stop heat dissipation. This can avoid a case in which the second electronic device still works when the temperature of the first electronic device is already low.

In some embodiments, the method 700 further includes:
When the first electronic device is in a first state, the first electronic device stops supplying power to the second electronic device.

For example, the first state may include but is not limited to a voice call state, a video call state, a recording state, or a low battery level state.

According to this embodiment of this application, because the second electronic device relies on power supply of the first electronic device to work, and the second electronic device generates vibration during working, when the first electronic device is in the first state, the first electronic device may stop supplying power to the second electronic device, to reduce impact on a current service of the first electronic device or reduce power consumption of the first electronic device.

In some embodiments, before the first electronic device controls, at the first power, the second electronic device to drive the heat dissipation medium to move, the method 700 further includes:
The first electronic device obtains device information of the second electronic device; and
the first electronic device determines, based on the device information, that the second electronic device is a heat dissipation device.

In some implementations, when the first electronic device supplies power to the second electronic device by using the wireless reverse charging function, the first electronic device may obtain the device information of the second electronic device by using a wireless charging protocol. The device information may include one or more of information such as a product serial number, a product type, configuration information, and a MAC address of the second electronic device.

For example, the first electronic device may send a request message to the second electronic device, and after receiving the request message, the second electronic device sends the device information of the second electronic device to the first electronic device, so that the first electronic device can obtain the device information of the second electronic device.

For another example, after the first electronic device wirelessly supplies power to the second electronic device, the second electronic device may actively send the device information of the second electronic device to the first electronic device.

According to this embodiment of this application, the first electronic device may further obtain the device information of the second electronic device, and further determine, based on the device information, that the second electronic device is a heat dissipation device. This technical solution helps the first electronic device determine a device type of the second electronic device.

In some embodiments, the method 700 further includes:
when the second electronic device is attached to the first electronic device for the first time, controlling the second electronic device to drive the heat dissipation medium to move for second preset duration; or
when the second electronic device is attached to the first electronic device for the non-first time, the first electronic device stops supplying power to the second electronic device.

A specific value of the second preset duration is not limited in embodiments of this application. For example, the second preset duration may be 1 minute or 2 minutes.

It should be understood that, when the second electronic device is attached to the first electronic device for the non-first time, a prerequisite for the first electronic device to stop supplying power to the second electronic device is that the temperature of the first electronic device in this case is low and does not exceed a preset value.

According to this embodiment of this application, when the second electronic device is attached to the first electronic device for the first time, the first electronic device may further control the second electronic device to work for the second preset duration, to present, to a user, effect of dissipating heat from the first electronic device by the second electronic device. When the second electronic device is attached to the first electronic device for the non-first time, the first electronic device stops supplying power to the second electronic device, to reduce power consumption.

In some embodiments, before supplying power to the second electronic device, the method 700 further includes:
The first electronic device determines, by using a Hall component, that the second electronic device is attached to the first electronic device.

According to this embodiment of this application, the first electronic device can conveniently determine, by using the Hall component, whether the second electronic device is attached.

In some embodiments, the method 700 further includes:
The first electronic device supplies power to the second electronic device or stops supplying power to the second electronic device based on an operation of a user.

In some implementations, a display interface for a battery of the first electronic device may include a wireless reverse charging function button, and the user may control, by using the wireless reverse charging function button, the first electronic device to supply power to the second electronic device or stop supplying power to the second electronic device.

According to this embodiment of this application, the first electronic device may further supply power to the second electronic device or stop supplying power to the second electronic device based on the operation of the user. In this way, the user can autonomously determine whether to have the second electronic device dissipate heat from the first electronic device.

In some embodiments, that the first electronic device supplies power to the second electronic device includes:
The first electronic device supplies power to the second electronic device in a wireless reverse charging manner.

According to this embodiment of this application, the first electronic device may have a wireless reverse charging function, to conveniently supply power to the attached second electronic device.

In another example, the first electronic device may alternatively supply power to the second electronic device in a wired manner. This is not limited in embodiments of this application.

In some embodiments, that the second electronic device drives, at the first power, the heat dissipation medium to move includes:
The second electronic device receives the first indication information sent by the first electronic device; and
the second electronic device drives, based on the first indication information at the first power, the heat dissipation medium to move.

According to this embodiment of this application, the second electronic device may receive the first indication information sent by the first electronic device, and drive, based on the first indication information at the first power, the heat dissipation medium to move. In this way, the first electronic device can accurately control a driving force used by the second electronic device to work.

In some embodiments, the method 700 further includes:
After the first preset duration, the second electronic device drives, at the second power, the heat dissipation medium to move, where the second power is less than the first power.

According to this embodiment of this application, after the heat dissipation medium starts to flow, a smaller driving force is required. In this case, the second electronic device may drive, at the second power, the heat dissipation medium to move, to reduce power consumption.

In some embodiments, the method 700 further includes:
The second electronic device receives the second indication information sent by the first electronic device; and
the second electronic device drives, based on the second indication information at the third power, the heat dissipation medium to move, where the third power is less than the first power.

According to this embodiment of this application, the second electronic device may further receive the second indication information sent by the first electronic device, and drive, based on the second indication information at the third power less than the first power, the heat dissipation medium to move. This technical solution can reduce power consumption of the first electronic device.

FIG. 9 is a block diagram of an electronic device according to an embodiment of this application. As shown in FIG. 9, the electronic device 800 may include one or more processors 810 and one or more memories 820. The one or more memories 820 store one or more instructions. When the instructions are executed by the one or more processors 810, the heat dissipation method according to any one of the foregoing possible implementations is performed.

For example, the electronic device 800 may be the foregoing first electronic device, second electronic device, heat dissipation device 200, electronic device 300, or the like.

An embodiment of this application further provides an apparatus, including a processor and a communication interface. The communication interface is configured to receive a signal and transmit the signal to the processor, and the processor processes the signal, so that the heat dissipation method according to any one of the foregoing possible implementations is performed.

The apparatus may be a chip. For example, the chip may be a chip system or an independent chip.

An embodiment of this application further provides a readable storage medium. The readable storage medium stores instructions. When the instructions are run on an electronic device, the electronic device is enabled to perform the foregoing related method steps, to implement the heat dissipation method in the foregoing embodiments.

An embodiment of this application further provides a program product. When the program product is run on an electronic device, the electronic device is enabled to perform the foregoing related steps, to implement the heat dissipation method in the foregoing embodiments.

An embodiment of this application further provides a system, including the first electronic device and the second electronic device described above.

An embodiment of this application further provides a heat dissipation apparatus, including a module configured to implement the heat dissipation method in any one of the foregoing embodiments.

In addition, an embodiment of this application further provides an apparatus. The apparatus may be specifically a chip, a component, or a module. The apparatus may include a processor and a memory that are connected. The memory is configured to store instructions. When the apparatus runs, the processor may execute the instructions stored in the memory, to enable the apparatus to perform the heat dissipation method in the foregoing method embodiments.

The device, the readable storage medium, the program product, or the apparatus provided in embodiments is configured to perform the corresponding methods provided above. Therefore, for beneficial effects that can be achieved, refer to beneficial effects of the corresponding methods provided above. Details are not described herein again.

A person of ordinary skill in the art may be aware that, units and algorithm steps in the examples described with reference to embodiments disclosed in this specification can be implemented by electronic hardware or a combination of computer software and electronic hardware. Whether these functions are performed by hardware or software depends on particular applications and design constraints of the technical solutions. A person skilled in the art may use different methods to implement the described functions for each particular application, but it shall not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiments are merely examples. For example, division into the units is merely logical function division and may be other division during actual implementation. For example, a plurality of units or components may be combined or may be integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or other forms.

The units described as separate parts may or may not be physically separate, and parts displayed as units may or may not be physical units, may be located in one position, or may be distributed on a plurality of network units. Some or all of the units may be selected according to actual requirements to achieve the objectives of the solutions of embodiments.

In addition, functional units in embodiments of this application may be integrated into one processing unit, each of the units may exist alone physically, or two or more units may be integrated into one unit.

When the functions are implemented in a form of software functional unit and sold or used as an independent product, the functions may be stored in a computer-readable storage medium. Based on such an understanding, the technical solutions of this application essentially, or the part contributing to the conventional technology, or some of the technical solutions may be implemented in a form of software product. The computer software product is stored in a storage medium, and includes several instructions for instructing a computer device (which may be a personal computer, a server, a network device, or the like) to perform all or some of the steps of the methods described in embodiments of this application. The foregoing storage medium includes any medium that can store program code, such as a USB flash drive, a removable hard disk, a read-only memory, a random access memory, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation method, wherein the method is applied to a first electronic device, and the method comprises:
when a second electronic device is attached to the first electronic device, obtaining a temperature of the first electronic device; and
when the temperature of the first electronic device is greater than or equal to a first preset value, supplying power to the second electronic device, and controlling, at a first power, the second electronic device to drive a heat dissipation medium to move.

2. The method according to claim 1, wherein controlling, at the first power, the second electronic device to drive the heat dissipation medium to move comprises:
sending first indication information to the second electronic device, wherein the first indication information indicates the second electronic device to drive, at the first power, the heat dissipation medium to move.

3. The method according to claim 1 or 2, wherein the method further comprises:
after first preset duration, controlling, at a second power, the second electronic device to drive the heat dissipation medium to move, wherein the second power is less than the first power.

4. The method according to any one of claims 1 to 3, wherein the method further comprises:
when the temperature of the first electronic device is greater than or equal to a second preset value and is less than the first preset value, sending second indication information to the second electronic device, wherein the second indication information indicates the second electronic device to drive, at a third power, the heat dissipation medium to move, and the third power is less than the first power.

5. The method according to claim 4, wherein the method further comprises:
when the temperature of the first electronic device is less than the second preset value, stopping, by the first electronic device, supplying power to the second electronic device.

6. The method according to any one of claims 1 to 4, wherein the method further comprises:
when the first electronic device is in a first state, stopping, by the first electronic device, supplying power to the second electronic device.

7. The method according to any one of claims 1 to 6, wherein before controlling, at the first power, the second electronic device to drive the heat dissipation medium to move, the method further comprises:
obtaining device information of the second electronic device; and
determining, based on the device information, that the second electronic device is a heat dissipation device.

8. The method according to claim 7, wherein the method further comprises:
when the second electronic device is attached to the first electronic device for the first time, controlling the second electronic device to drive the heat dissipation medium to move for second preset duration; or
when the second electronic device is attached to the first electronic device for the non-first time, stopping, by the first electronic device, supplying power to the second electronic device.

9. The method according to any one of claims 1 to 8, wherein before supplying power to the second electronic device, the method further comprises:
determining, by using a Hall component, that the second electronic device is attached to the first electronic device.

10. The method according to any one of claims 1 to 9, wherein the method further comprises:
supplying, by the first electronic device based on an operation of a user, power to the second electronic device or stopping supplying power to the second electronic device.

11. The method according to any one of claims 1 to 10, wherein supplying power to the second electronic device comprises:
supplying power to the second electronic device in a wireless reverse charging manner.

12. A heat dissipation method, wherein the method is applied to a second electronic device, and the method comprises:
receiving power supplied by a first electronic device; and
driving, at a first power, a heat dissipation medium to move.

13. The method according to claim 12, wherein driving, at the first power, the heat dissipation medium to move comprises:
receiving first indication information sent by the first electronic device; and
driving, based on the first indication information at the first power, the heat dissipation medium to move.

14. The method according to claim 13, wherein the method further comprises:
after first preset duration, driving, at a second power, the heat dissipation medium to move, wherein the second power is less than the first power.

15. The method according to any one of claims 12 to 14, wherein the method further comprises:
receiving second indication information sent by the first electronic device; and
driving, based on the second indication information at a third power, the heat dissipation medium to move, wherein the third power is less than the first power.

16. An electronic device, comprising one or more processors and one or more memories, wherein the one or more memories store one or more programs, and when the one or more programs are executed by the one or more processors, the heat dissipation method according to any one of claims 1 to 11 is performed, or the heat dissipation method according to any one of claims 12 to 15 is performed.

17. A chip, wherein the chip comprises a processor and a communication interface, the communication interface is configured to receive a signal and transmit the signal to the processor, and the processor processes the signal, so that the heat dissipation method according to any one of claims 1 to 11 is performed, or the heat dissipation method according to any one of claims 12 to 15 is performed.

18. A readable storage medium, wherein the readable storage medium stores instructions, and when the instructions are run on an electronic device, the heat dissipation method according to any one of claims 1 to 11 is performed, or the heat dissipation method according to any one of claims 12 to 15 is performed.
